# DEMANDE DE BREVET EUROPEEN

(11) **EP 0 779 380 A1**
(43) Date de publication de la demande: **18.06.1997**
(21) Numéro de dépôt: 96402651.2
(22) Date de dépôt: 06.12.1996
(51) Int. Cl.: C30B 25/02, C30B 29/40

(54) **Matériau semiconducteur III-V et Composant électronique comprenant ce matériau**

(30) Priorité: 15.12.1995 FR 9514913
(71) Demandeur: THOMSON-CSF, 75008 Paris (FR)
(72) Inventeur: Brylinski, Christian, Thomson-CSF SCPI, 94117 Arcueil Cedex (FR); Poisson, Marie-Antoinette, Thomson-CSF SCPI, 94117 Arcueil Cedex (FR)

(57) **Abrégé**

L'invention concerne un matériau semiconducteur III-V obtenu par hétéroépitaxie sur un substrat de cristal de type "cassitérite" cristallisant dans un système tétragonal. Ce matériau semiconducteur III-V peut avantageusement être un alliage ternaire de type Ga₁₋ₓInₓN, Al₁₋ₓInₓN, etc..., il présente dans ces conditions d'élaboration une très faible densité de défauts.

Applications : Lasers, diodes électroluminescentes.

## Description

Le domaine de l'invention est celui des semiconducteurs à grande bande interdite de type composés semiconducteurs comprenant au moins un élément de valence III et au moins un élément de valence V. Il s'agit plus précisément notamment d'alliage de composés BN, AIN, GaN et InN entre eux et avec des phosphures, arséniures ou antimoniures d'éléments de valence III.

Les propriétés semiconductrices de ces alliages sont connues depuis longtemps et permettent à l'heure actuelle de chercher à les employer dans des lasers ou des diodes électroluminescentes émettant dans le visible ou le proche ultraviolet.

Le problème majeur existant, réside dans la fabrication de ces alliages. Actuellement cette fabrication n'est relativement répandue que sous la forme de couches minces réalisées par hétéroépitaxie (large-band gap SiC, III-V nitride and Il-Vi ZnSe based semiconductor device technology, H. Morkoç, S. Strite, G.B. Gao, M.E. Lin and M. Burns, J. Appl. Phys. 76 (3), 1 Aug. 1994, pp. 1363-1266, University of Illinois, IBM Research Division Zürich).

En effet, il a été démontré que la majorité des composés III-V semiconducteurs peut cristalliser selon l'un des deux systèmes suivants : hexagonal de type "würtzite" et/ou cubique de type "sphalérite". Dans le cas où les deux polytypes existent, la variété héxagonale est celle que l'on obtient le plus facilement sur un substrat cristallin de symétrie hexagonale par exemple le saphir ou α-SiC. La variété cristalline cubique peut être obtenue dans certaines conditions de croissance le plus souvent sur un substrat cristallin de symétrique cubique par exemple MgO ou Si.

Actuellement, le procédé de fabrication le plus utilisé fait appel à une épitaxie sur un substrat hexagonal type saphir (Al₂O₃) ou SiC dont la fabrication reste néanmoins difficile et le coût élevé.

De plus, le saphir cristallise dans une structure hexagonale différente de celle des cristaux semiconducteurs III-V et présente un fort désaccord de paramètre de réseau. SiC présente une désadaptation de maille, moins prononcée que Al₂O₃ vis-à-vis de ces semiconducteurs, cependant les densités de défauts (essentiellement dislocations, fautes d'empilement, fissures) des couches de composés III-V obtenues par hétéroépitaxie sur SiC restent très importantes. Cette densité de défauts étendus est d'au moins 10⁹ cm-² près du substrat et reste très supérieure à 10⁷ cm-² dans la couche active des composants.

Tous les problèmes actuellement rencontrés en matière de densité de défauts due à une mauvaise adaptation de maille entre semiconducteurs et substrat représentent des inconvénients majeurs pour envisager des applications de ces composés semiconducteurs dans des dispositifs type laser, diode électroluminescente...

Dans ce contexte, l'invention propose d'utiliser un type de substrat original dans le cadre de la croissance des composés semiconducteurs III-V. Ce type de substrat ne cristallise pas dans les phases classiques hexagonales ou cubiques auxquelles on est amené spontanément à penser lorsque l'on s'intéresse à la fabrication des semiconducteurs III-V.

Plus précisément, il est proposé d'utiliser selon l'invention, des cristaux cristallisant dans une phase tétraédrique du système "cassitérite", comme substrats pour faire croître par hétéroépitaxie des semiconducteurs III-V. La plupart des cristaux cristallisant dans ce système sont des difluorures d'éléments divalents (exemple MgF₂) ou des di-oxydes d'éléments tétravalents (exemple TiO₂).

Ainsi l'invention a pour objet un matériau semiconducteur III-V caractérisé en ce qu'il est obtenu par hétéroépitaxie sur un substrat de cristal de type "cassitérite" cristallisant dans un système tétragonal.

Le cristal de type cassitérite peut avantageusement être un cristal de type M₂F₂ avec M₂ élément de valence Il en particulier l'un des éléments suivants : Co, Fe, Mg, Mn, Ni, Pd, Zn et leurs alliages ternaires ou multiples.

Le cristal de type cassitérite peut également avantageusement être de type M₄O₂ avec M₄ un élément de valence IV, en particulier l'un des éléments suivants : Cr, Ir, Ge, Mn, Mo, Nb, Os, Pb, Ru, Sn, Ta, Te, Ti, W et leurs alliages ternaires ou multiples.

Le cristal de type cassitérite peut encore avantageusement être de type M₃M₅O₄ avec M₃ un élément de valence III, M₅ un élément de valence V et en particulier le couple M₃M₅ pouvant être l'un des couples suivants : AlSb, CrNb, CrSb, CrTa, FeNb, FeSb, FeTa, GaSb, RhNb, RhSb, RhTa, RbV.

Le matériau III-V semiconducteur peut typiquement être un alliage ternaire ou quaternaire d'éléments de valence III de type B, AI ou In et d'éléments de valence V de type N ou P. Il peut ainsi s'agir de composés GaₓIn₁₋ₓN, AlₓIn₁₋ₓN, BₓIn₁₋ₓ, GaNₓP₁₋ₓ, AlNₓP₁₋ₓ dont le paramètre de maille aₒ peut être rendu égal à celui du cristal cassitérite retenu par un choix judicieux du paramètre de composition x.

L'invention a aussi pour objet un composant électronique à base de matériau III-V semiconducteur caractérisé en ce qu'il comprend un substrat de cristal de type "cassitérite" cristallisant dans un système tétragonal et une couche de matériau III-V à la surface dudit substrat.

Le cristal de type "cassitérite" peut avantageusement être l'un des cristaux cités précédemment.

Le matériau III-V semiconducteur ainsi obtenu sur ce type de substrat présente de très bonnes propriétés en raison du faible taux obtenu de défauts. Il peut lui-même jouer le rôle de substrat sur lequel on peut envisager une nouvelle épitaxie.

L'invention sera mieux comprise et d'autres avantages apparaîtront à la lecture de la description qui va suivre, donnée à titre non limitatif et grâce aux figures annexées parmi lesquelles :
- la figure 1 représente une vue en projection sur une face carrée (100) des positions atomiques dans la maille tétragonale d'un cristal "cassitérite" de MgF₂ ;
- la figure 2 représente une vue en projection sur une face carrée (100) des positions atomiques dans la maille tétragonale d'un cristal "sphalérite" de GaN ;
- la figure 3 est relative à un tableau donnant le paramètre de maille aₒ (Å) pour différents composés cristallisant dans le système "cassitérite".

Le composant électronique selon l'invention comprend, un substrat de cristal cristallisant dans une phase tétragonale tel que le cristal SnO₂, encore dénommé usuellement cristal "cassitérite". La maille élémentaire de la phase tétragonale est un parallélépipède rectangle à base carrée. Le paramètre aₒ représente le côté du carré de base de la maille. Ce carré est inclus dans un plan cristallin de la famille <100>. C'est à priori sur un plan de cette famille qu'il serait le plus facile de faire croître un cristal de type cubique sphalérite et en particulier un composé semiconducteur III-V.

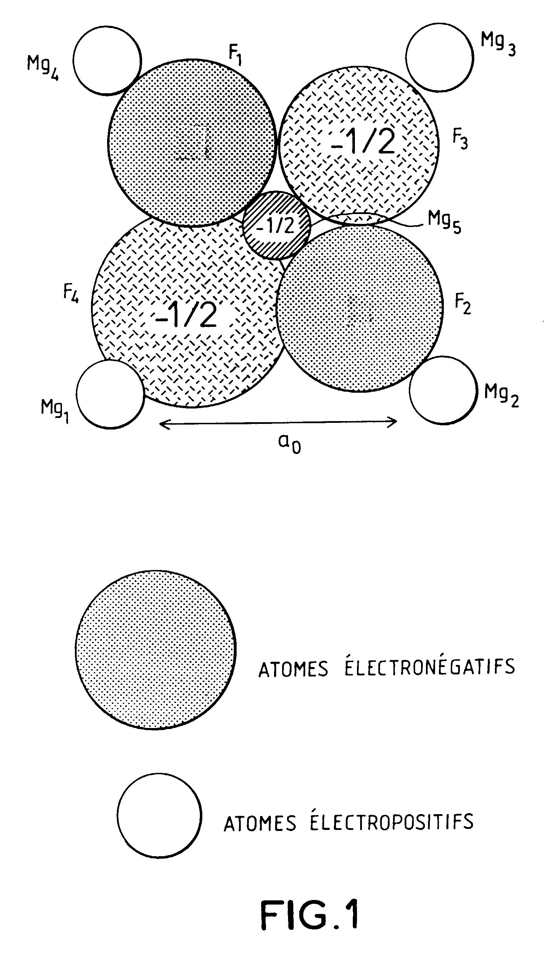

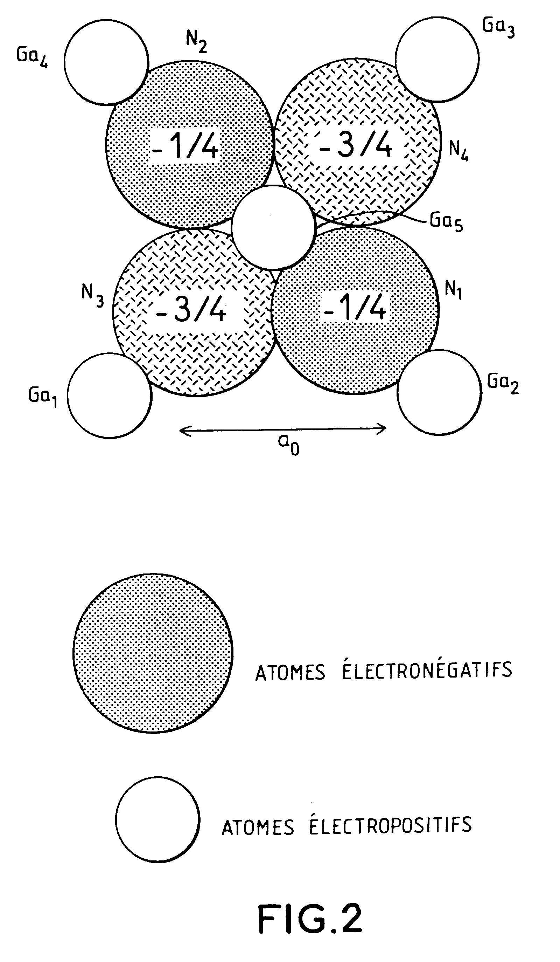

De plus, comme l'illustre la comparaison des figures 1 et 2, il ressort que les cristaux cassitérite et sphalérite présentent une symétrie d'ordre 2.

Plus précisément, la figure 1 représente une face carrée dans le plan 100 et montre que 4 atomes Mg₁, Mg₂, Mg₃, Mg₄ électropositifs de magnésium sont centrés sur un plan, disposés sur un carré de côté aₒ correspondant au paramètre de maille. Deux atomes électronégatifs de fluor F₁ et F₂ centrés sur le même plan que les atomes Mg₁, Mg₂, Mg₃, Mg₄ ; deux autres atomes de fluor F₃ et F₄ sont situés dans le même plan qu'un cinquième atome de magnésium Mg₅ localisé au centre de la maille élémentaire tétragonale.

La figure 2 représente une face carrée (plan <100>) de la maille élémentaire d'un cristal sphalérite GaN et montre que cinq atomes de gallium Ga₁, Ga₂, Ga₃, Ga₄, Ga₅ sont dans un même plan, 4 atomes étant disposés selon un carré de côté aₒ, un atome étant au centre de ce carré, deux atomes N₁ et N₂ étant situés dans un plan situé à une distance -1/4 aₒ du plan défini par les atomes de gallium, deux autres atomes d'azote N₃ et N₄ étant dans un plan situé à une distance -3/4 aₒ du plan contenant l'ensemble des atomes de gallium. L'examen de l'arrangement atomique des deux types de phase cristalline tétraédrique et cubique, montre la compatibilité de ces deux types de cristaux, conduisant à une croissance possible d'un cristal cubique du système sphalérite sur une face cristalline parallèle à une face carrée de la maille élémentaire d'un cristal "cassitérite".

Le démarrage de l'hétéroépitaxie peut se faire par exemple selon le mécanisme d'accrochage suivant qui comporte principalement deux étapes :
- La substitution des éléments électronégatifs du cristal cassitérite par des éléments de la colonne V par exemple par chauffage du cristal germe "cassitérite" sous une atmosphère gazeuse contenant une pression partielle suffisante de ces éléments V.

Dans le cas de MgF₂, les éléments F peuvent par exemple se combiner avec des éléments N ou H pour former des espèces gazeuses NF₃ ou HF et autoriser la substitution des éléments F de surface par des atomes d'éléments V.

Dans le cas de TiO₂, les éléments O peuvent se combiner avec des éléments N ou H pour former des espèces gazeuses NOₓ ou H₂O et autoriser la substitution des éléments O de surface par des atomes d'éléments V.
- Un accrochage des éléments électropositifs du cristal sphalérite sur les éléments électronégatifs V substitués en surface du cristal de type "cassitérite".

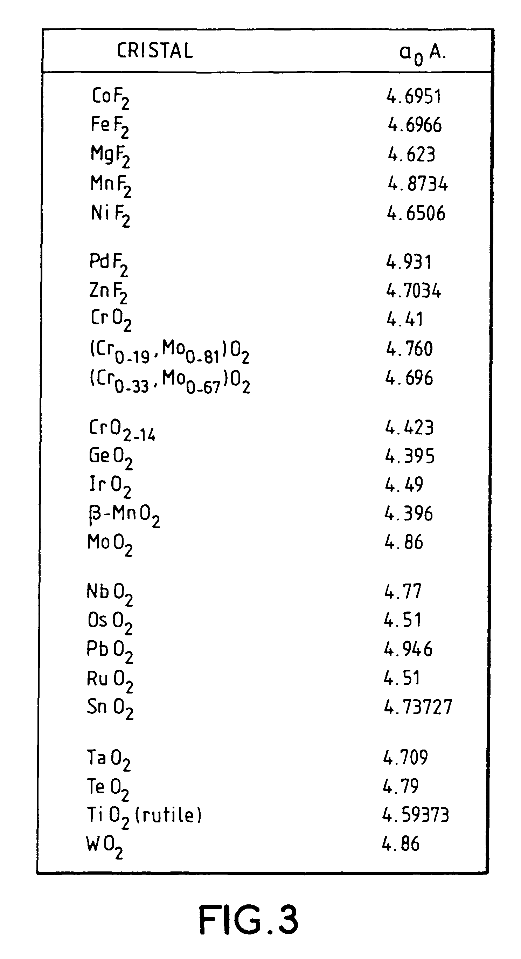

De plus les paramètres de réseau aₒ des faces carrées des principaux cristaux du système cassitérite sont compris entre 4,40 et 5Å comme l'indique le tableau de la figure 3, ce qui rend possible l'adaptation de tels substrats à de nombreuses familles de composés III-V semiconducteurs, parmi lesquelles figurent des alliages de type Ga₁₋ₓInₓN, Al₁₋ₓInₓN, B₁₋ₓInₓN, B₁₋ₓGaₓP, B₁₋ₓInₓP, AlP₁₋ₓNₓ.

A titre d'exemple, les tables ci-après fournissent des composés semiconducteurs ternaires, dont le paramètre de maille aₒ est très proche de celui du substrat de type "cassitérite associé" (variation relative du paramètre aₒ inférieure à 3.10⁻³).

On peut déterminer les paramètres de maille de composés ternaires à partir des paramètres de mailles des composés binaires, en utilisant la loi de Végard.

Les paramètres aₒ(Å) de certains composés binaires sont fournis dans le tableau ci-après.

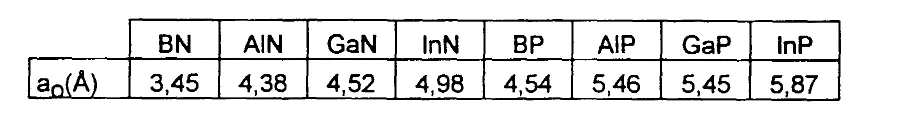

En réalisant des composés ternaires, il est possible d'obtenir une adaptation aussi fine que désirée du paramètre de réseau entre composés semiconducteurs et substrats comme l'illustrent les tableaux suivants pour lesquels cette condition est satisfaite.

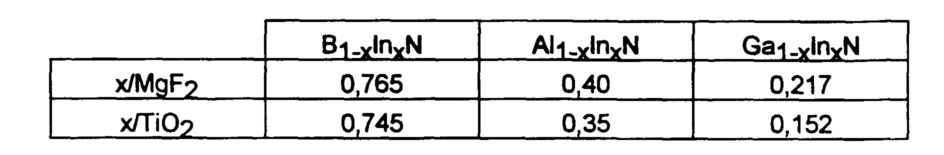

x/MgF₂ représente la fraction molaire qui permet une adaptation parfaite sur substrat MgF₂.

x/Tio₂ représente la fraction molaire qui permet une adaptation parfaite sur substrat TiO₂.

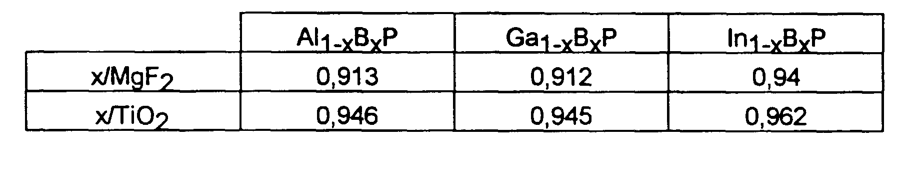

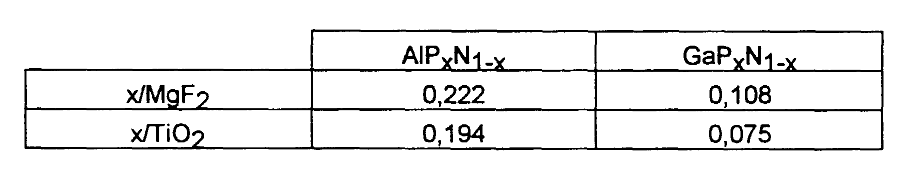

De plus, sur un substrat du système cassitérite, lorsque l'on dispose de plusieurs composés ternaires de maille adaptée par exemple sur un substrat de MgF₂, par exemple les composés Al_{0,6}In_{0,4}N et Ga_{0,783}In_{0,217}N, un mélange de ces deux composés ternaires reste adapté en maille au substrat considéré.

On peut ainsi régler la bande interdite (ou gap) du composé final semiconducteur permettant par la même de disposer d'un matériau semiconducteur dont les propriétés physiques sont adaptées aux applications auxquelles il est destiné, notamment en matière de diode laser.

Selon un mode de réalisation de l'invention, conduisant à la fabrication d'un composant comprenant un cristal semiconducteur III-V et un substrat de MgF₂, on utilise une plaque de monocristal à faces à peu près parallèles, d'une épaisseur typiquement de 0,5 mm. Cette plaque est découpée de manière à ce que les faces de la plaque soient perpendiculaires à la direction cristallographique <c> du réseau ou légèrement désorientées par rapport à cette direction perpendiculaire (d'un angle inférieur à 10 degrés). Une face de cette plaque est polie.

Après un nettoyage approprié : par exemple un dégraissage ou une légère attaque acide, on introduit cette plaque dans un réacteur d'épitaxie en phase vapeur à partir d'organométalliques (MOCVD) et on réalise un cycle d'épitaxie de composé semiconducteur III-V.

Ce cycle comprend une montée en température sous atmosphère d'hydrogène et/ou d'azote éventuellement avec addition d'ammoniac ou d'organométallique d'élément III pour stabiliser la surface du cristal.

Il comprend l'épitaxie de semiconducteurs III-V à partir d'organométalliques d'éléments III : par exemple du Tri-Ethyl-Gallium, du Tri-Ethyl-Aluminium, du Tri-Ethyl-lndium, du Tri-Ethyl-Bore et de l'ammoniac pour assurer l'apport d'élément azoté.

Il comprend enfin la redescente en température sous atmosphère d'hydrogène et/ou d'azote, avec addition d'ammoniac pour stabiliser la surface du cristal.

## Revendications

1. Matériau semiconducteur III-V, caractérisé en ce qu'il est obtenu par hétéroépitaxie sur un substrat de type "cassitérite" cristallisant dans un système tétragonal.

2. Matériau semiconducteur III-V selon la revendication 1, caractérisé en ce que le cristal de type "cassitérite" est de type M₂F₂, M₂ étant un élément de valence Il et en particulier : CO, Fe, Mg, Mn, Ni, Pd, Zn ou un alliage ternaire ou multiple d'éléments de valence Il.

3. Matériau semiconducteur III-V selon la revendication 1, caractérisé en ce que le cristal de type "cassitérite" est de type M₄O₂, M₄ étant un élément de valence IV et en particulier : Ru, Sn, Ta, Te, Ti, W ou un alliage ternaire ou multiple d'éléments de valence IV.

4. Matériau semiconducteur III-V selon la revendication 1, caractérisé en ce que le cristal de type "cassitérite" est de type M₃M₅O₄ avec M₃ un élément de valence III, M₅ un élément de valence V et en particulier le couple M₃M₅ étant AlSb, CrNb, CrSb, CrTa, FeNh, FeSb, FeTa, GaSb, RhNb, RhSb, RhTa, RbV.

5. Matériau semiconducteur III-V selon la revendication 1, caractérisé en ce que le cristal de type "cassitérite" est de type zircone ZrO₂.

6. Matériau semiconducteur III-V selon l'une des revendications 1 à 5, caractérisé en ce que le matériau hétéroépitaxié est un alliage ternaire de type : B₁₋ₓInₓN, Al₁₋ₓInₓN, Ga₁₋ₓInₓN, Al₁₋ₓBₓP, Ga₁₋ₓBₓP, In₁₋ₓBₓP, AlPₓN₁₋ₓ, ou un mélange desdits alliages ternaires.

7. Composant électronique à base de matériau III-V semiconducteur, caractérisé en ce qu'il comprend un substrat de cristal de type "cassitérite" cristallisant dans un système tétragonal et une couche de matériau III-V à la surface dudit substrat.
